Europäisches Patentamt

European Patent Office

Office européen des brevets

(11) Publication number: **0 271 932**
**A2**

# EUROPEAN PATENT APPLICATION

(21) Application number: **87202038.3**

(22) Date of filing: **23.10.87**

(51) Int. Cl.4: **H01L 27/10** , H01L 29/78 ,
//G11C17/00

(30) Priority: **18.11.86 IT 2237286**

(43) Date of publication of application:
**22.06.88 Bulletin  88/25**

(84) Designated Contracting States:
**DE FR GB NL**

(71) Applicant: SGS-THOMSON
MICROELECTRONICS S.p.A.
Stradale Primosole 50
I-95121 Catania(IT)

(72) Inventor: Riva, Carlo
Via S. Pellico, 24/B
I-20052 Monza Milano(IT)

(74) Representative: Mittler, Enrico et al
c/o Marchi & Mittler s.r.l. Viale Lombardia, 20
I-20131 Milano(IT)

(54) **EEPROM memory cell with two levels of polysilicon and a tunnel oxide zone.**

(57) The cell comprises a selection transistor (51), a pickup transistor (52), a thin oxide zone (56), a floating gate (58) superimposed on said thin oxide zone (56) and made with a first layer of polysilicon (57) in a single piece with a first gate (59) of the pickup transistor (52), and a control gate (61) superimposed on said first gate (59) of the pickup transistor (52) and made with a second polysilicon layer (61). The latter also forms the selection transistor gate (51) in a single piece.

Fig.2

**"EEPROM memory cell with two levels of polysilicon and a tunnel oxide zone"**

The present invention relates to an EEPROM memory cell with two levels of polysilicon programmable for a Fowler-Nordheim tunnel through a thin oxide zone.

Cells of this type are known to comprise a zone of thin oxide or tunnel oxide placed between a selection transistor and a pickup transistor. A first layer of polysilicon forms the gate of the selection transistor and separately a floating gate superimposed on the thin oxide zone and accomplished in a single piece with a first gate of the pickup transistor. A second layer of polysilicon superimposed on the first by interposing insulating oxide forms the common control gate for the thin oxide zone and the pickup transistor.

These cells have the virtue of presenting good reliability characteristics but pay for it in terms of area occupied and masking used in making them.

The object of the present invention is to achieve an EEPROM memory cell with two levels of polysilicon and tunnel oxide zones which would present greater compactness and technological simplicity while maintaining intact the reliability characteristics of the conventional cells of the same type.

In accordance with the invention said object is achieved by an EEPROM cell comprising a selection transistor, a pickup transistor, a thin oxide zone, a floating gate superimposed on said thin oxide zone and made with a first layer of polysilicon in a single piece with a first gate of the pickup transistor, and a control gate superimposed on said first gate of the pickup transistor and made with a second layer of polysilicon characterized in that said second layer of polysilicon also forms in a single piece the gate of the selection transistor.

In other words, the EEPROM cell in accordance with the present invention does not provide the selection transistor as an element separate from the others but utilizes for its functions a portion of the second polysilicon layer, i.e. of the control gate.

With no loss of reliability, the memory cell in accordance with the invention can thus be made more simply and in a more compact form.

The characteristics of the present invention will be better understood by observing the annexed drawings wherein:

FIG. 1 shows schematically a plan of the conformation of an EEPROM cell in accordance with the previous art,

FIG. 2 shows a similar plan representation of an EEPROM cell in accordance with the invention,

FIG. 3 shows a cross section of the the cell in accordance with the invention along line III-III of FIG. 2, and

FIG. 4 shows a cross section of the cell in accordance with the invention along line IV-IV of FIG. 2.

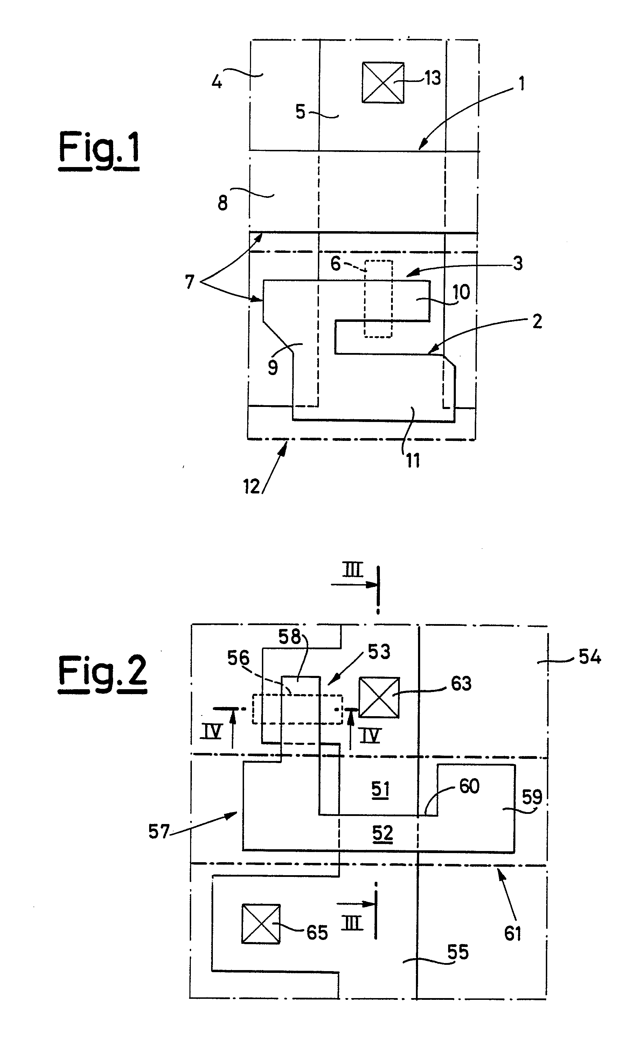

With reference to FIG. 1 there is illustrated an EEPROM memory cell in accordance with the known art which comprises a selection tansistor 1, a pickup transistor 2 and a tunnel area 3 placed between the two transistors.

More precisely, on an oppropriately doped semiconductor substrate 4 there is provided an active area 5 presenting a thin oxide or tunnel oxide zone 6. On the active area 5, with the exception of the thin oxide zone 6, is grown a gate oxide on which is deposited a first layer of polysilicon or polycrystalline silicon 7 formed by a straight strip 8 defining the gate of the selection transistor 1 and separately a C-shaped strip 9 a branch 10 of which defines the floating gate of the tunnel area 3 while the other arm 11 defines a first gate of the pickup transistor 2. A second layer of polysilicon 12 in the form of a straight strip is placed above said first polysilicon strip 9 (with interposed insulating oxide) to define the control gate for the pickup transistor 2 and the tunnel area 3. Reference number 13 indicates the drain contact of the memory cell shifted axially in relation to the selection transistor 51.

FIGS. 2-4 illustrate an EEPROM memory cell in accordance with the invention in which the selection transistor is indicated with reference number 51, the pickup transistor is indicated with reference number 52 and the tunnel area is indicated with reference number 53.

As shown in FIG. 2 the selection transistor 51 and the pickup transistor 52 are side-by-side while the tunnel area is shifted sidewise in relation to the two transistors.

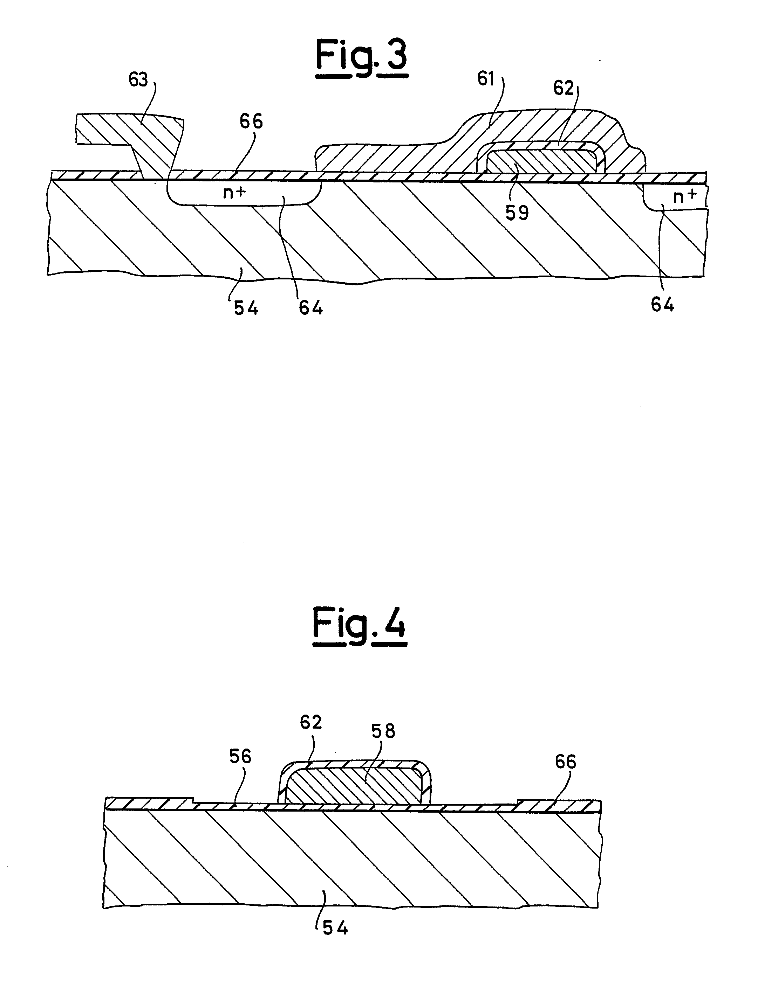

In detail, on a semiconductor substrate 54 having an (n ) doped area 64 is provided an active area 55 presenting a thin oxide or tunnel oxide zone 56 (FIGS. 2 and 4). On the active area 55 with the exception of the thin oxide zone 56 is grown a gate oxide 66 on which is deposited a first layer of polysilicon or polycrystalline silicon 57 formed of a laterally shifted axial branch 58 defining the floating gate of the tunnel area 53 and a transversal arm 59 defining a first gate of the pickup transistor 52 and having a central cavity 60. A second polysilicon layer 61 in the form of a straight strip is placed over said transverse arm 59 of the first polysilicon layer 57 (with interposed insulating oxide 62 also placed over the floating gate 58) to define the control gate of the pickup transistor 52 and, inside the cavity 60, the gate of the selection transistor 51 (FIGS. 2 and 3). Reference number 63 indicates the drain contact of the memory cell moved axially in relation to the transistors 51 and 52 but beside the tunnel area 53. Reference number 65 indicates the output contact of said memory cell.

The EEPROM memory cell illustated in FIGS. 2-4 is capable of operating as follows.

In the writing phases the drain contact 63 is placed at a high level while the second polysilicon layer 61 is grounded. In this manner the selection transistor 51 is estinguished and no axial current passes so that the drain contact 63 remains high. Furthermore, due to the effect of the capacitive couplings connected to the floating gate 58 and the control gate 61, voltage is discharged from the drain contact 63 on the floating gate 58, removing electrons from the latter and in this manner performing the 'writing' of the cell. Thanks to the pickup transistor 52 current passes between the two contacts 63 and 65.

In the cancellation phase the second polysilicon layer 61 is brought to high voltage while the drain contact 63 is grounded. The voltage is thus divided between the second polysilicon layer 61 and the drain contact 63 through the various capacitive couplings so that the floating gate 58 is charged with electrons and the pickup transistor 52 remains extinguished.

In the reading phase the control gate of the selection transistor 51 is brought to a voltage higher than its operating theshhold so as to open the electrical path of the drain contact 63 to the pickup transistor 52.

It should be noted that the cell thus formed lends itself to the simultaneous writing of an entire column of memory cells, since the high level of the drain contact 63 tends in any case to affect the other cells of the same column.

## Claims

1. EEPROM memory cell comprising a selection transistor (51), a pickup transistor (52), a thin oxide zone (56), a floating gate (58) superimposed on said thin oxide zone (56) and made with a first polysilicon layer (57) in a single piece with a first gate (59) of the pickup transistor (52) and a control gate (61) superimposed on said first gate (59) of the pickup transistor (52) and made with a second polysilicon layer (61) characterized in that said second polysilicon layer (61) also forms the selection transistor gate (51) in a single piece.

2. Memory cell in accordance with claim 1 characterized in that said first polysilicon layer (57) is formed of an axial branch shifted laterally (58) defining said floating gate (58) and a transverse branch (59) defining said first gate (59) of the pickup transistor (52) and having a central cavity (60) while said second polysilicon layer (61) is superimposed on said transverse branch (59) of the first polysilicon layer (57) and forms inside said cavity (60) the selection transistor gate (51).

3. Memory cell in accordance with claim 2 characterized in that it comprises a drain contact (63) shifted axially in relation to said transistors (51, 52) and beside said thin oxide zone (56).

Fig.1

Fig.2

## Fig.3

## Fig.4